# EUROPEAN PATENT APPLICATION

(11) **EP 2 858 095 A1**
(43) Date of publication of application: **08.04.2015**
(21) Application number: 13796377.3
(22) Date of filing: 19.04.2013
(51) Int. Cl.: H01L 21/265, H01L 21/20, H01L 21/26

(54) **SEMICONDUCTOR MANUFACTURING METHOD AND ANNEALING METHOD**

(30) Priority: 31.05.2012 JP 2012124230
(71) Applicant: Tokyo Electron Limited, Tokyo 107-6325 (JP)
(72) Inventor: WATANABE Yoshimasa, Nirasaki-shi Yamanashi 407-0192 (JP); SHIRAGA Kentaro, Nirasaki-shi Yamanashi 407-0192 (JP)
(74) Representative: Hoffmann Eitle
(86) International application number: PCT/JP2013/061619
(87) International publication number: WO 2013/179804

(57) **Abstract**

This invention has: a step for amorphizing the impurity diffusion layer formation region (step 1); a step for doping the impurity diffusion layer formation region in the semiconductor substrate with an impurity (step 2); and a step for applying an annealing treatment, including lamp annealing in which a heating lamp is used and microwave annealing in which microwaves are used, on the semiconductor substrate doped with the impurity, and activating the impurity (step 3). In addition to activation of the impurity, re-crystallization and repairing of crystal defects also take place in step 3. Step 1 is not a requirement.

## Description

### Field of the Invention

The present invention relates to a manufacturing method of a semiconductor device and an annealing method for forming an impurity diffusion layer by performing activation annealing after doping a semiconductor substrate with impurities.

### Background of the Invention

In a manufacturing process of a semiconductor device, there is a process of forming an impurity diffusion layer by performing impurity activation annealing after introducing impurities into a semiconductor substrate. Conventionally, lamp annealing of a short-time heat treatment at a high temperature of 1000°C or more is performed as an activation treatment of impurities.

Recently, with the miniaturization of the design rule of the semiconductor device, an annealing technique is demanded to suppress the thermal diffusion of impurities, and an annealing technique at a lower temperature has been studied. Further, as a technique for preventing diffusion of impurities, a technique using SPE (Solid Phase Epitaxy) has been known. In the case of applying the SPE to the impurity activation annealing, activation of impurities and recrystallization are performed by performing annealing at a low temperature after amorphizing an impurity doping region and doping the region with impurities (see, e.g., Patent Document 1).

(Patent Document 1) Japanese Patent Application Publication No. 2011-35371

However, in the annealing technique at a low temperature, defects generated during impurity doping may not be removed sufficiently. Particularly, when performing the SPE after performing the impurity doping in the amorphized region, most of crystal defects may remain in an end portion of the initially amorphized region. The remaining defects cause leakage current in the operation of the device.

### Summary of the Invention

In view of the above, the present invention provides a manufacturing method of a semiconductor device and an annealing method capable of sufficiently removing crystal defects even at a low temperature in impurity activation annealing after doping impurities into a semiconductor substrate.

In accordance with an aspect of the present invention, there is provided a method for manufacturing a semiconductor device. The method includes: doping impurities into an impurity diffusion layer forming region in a semiconductor substrate; and activating the impurities by performing, on the semiconductor substrate, an annealing treatment. The annealing treatment contains: lamp annealing performed by using heating lamps; and microwave annealing performed by microwave irradiation.

The annealing treatment is preferably performed at a temperature in a range of 300°C to 600°C. In the annealing treatment, the microwave annealing may be performed after the lamp annealing.

The method may further include, before the doping, amorphizing the impurity diffusion layer forming region. The amorphized impurity diffusion layer forming region may be recrystallized during the annealing treatment

In accordance with another aspect of the present invention, there is provided an annealing method for activating impurities after doping the impurities into an impurity diffusion layer forming region in a semiconductor substrate. The annealing method includes: lamp annealing performed by using heating lamps; and microwave annealing performed by microwave irradiation.

### Brief Description of the Drawings

Fig. 1 is a flowchart showing a manufacturing method of a semiconductor device in accordance with an embodiment of the present invention.
Fig. 2 is a schematic cross-sectional view showing an example of a microwave annealing apparatus used in microwave annealing.
Fig. 3 is a schematic cross-sectional view showing an example of a lamp annealing apparatus used in lamp annealing.
Fig. 4 is a diagram showing a relationship between the sheet resistance and the heating temperature of samples annealed in various ways after performing pre-amorphization and ion implantation.
Fig. 5 is a diagram showing CL spectra for a sample before annealing after performing pre-amorphization and ion implantation, a sample on which spike annealing was performed at 1000°C, a sample on which lamp annealing was singly performed at 600°C, a sample on which microwave annealing was singly performed at 600°C, samples on which lamp annealing and microwave annealing at 600°C were used in combination.
Fig. 6 is a diagram showing the intensity of W + W' of the CL spectra for a sample on which spike annealing was performed at 1000°C, a sample on which lamp annealing was singly performed at 600°C, a sample on which microwave annealing was singly performed at 600°C, a sample on which microwave annealing was performed at 600°C after lamp annealing was performed at 600°C, after performing pre-amorphization and ion implantation.
Fig. 7 shows TEM images of the cross-sections of a sample after performing pre-amorphization and ion implantation and a sample on which lamp annealing was performed for 10 min at 600°C, a sample on which microwave annealing was performed for 10 min at 600°C, and a sample on which microwave annealing was performed for 5 min at 600°C after lamp annealing was performed for 5 min at 600°C, after the ion implantation.

### Detailed Description of the Embodiments

Hereinafter, an embodiment of the present invention will be described in detail with reference to the accompanying drawings.

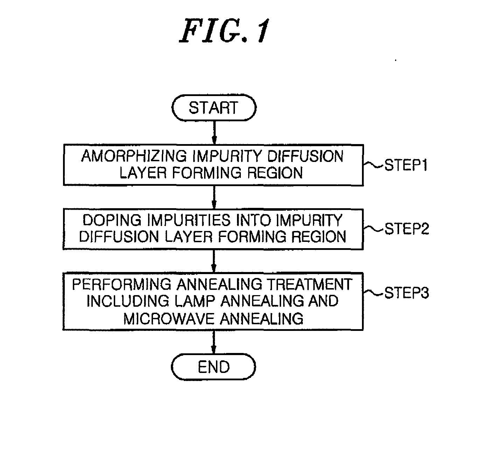

Fig. 1 is a flowchart showing a manufacturing method of a semiconductor device in accordance with an embodiment of the present invention.

First, an impurity diffusion layer forming region of a semiconductor wafer (semiconductor substrate) is amorphized at step 1. As examples of an impurity diffusion layer, there are a source electrode and a drain electrode of a MOS type semiconductor device.

By amorphizing the impurity diffusion layer forming region in this way, it is possible to increase the controllability of an implantation depth. Further, since a crystal grain boundary does not exist, impurity doping in the next step can be easily performed. Thus, even if subsequent annealing treatment is performed at a low temperature, activation of impurities and recrystallization (SPE) are possible.

In order to amorphize the impurity diffusion layer forming region, ion implantation of, e.g., Ge is performed under the conditions of, e.g., implantation energy in a range of 10 to 100 keV, and implantation dose in a range 1X 10¹⁴ to 5×10¹⁵ ions/cm². Ar, Kr or the like may be used instead of Ge.

Then, the amorphized impurity diffusion layer forming region is doped with impurities at step 2. Doping of the impurities can be performed by normal ion implantation. As the impurities, n-type impurities or p-type impurities may be used. The n-type impurities may include P and As, and the p-type impurities may include B.

For example, in the case of the p-type impurities including B, the doping of impurities by ion implantation is performed under the conditions of implantation energy in a range of 1 to 100 keV, and implantation dose in a range of 1 ×10¹⁵ to 5×10¹⁵ ions/cm².

Then, at step 3, annealing treatment including lamp annealing and microwave annealing is performed on the semiconductor wafer (semiconductor substrate) after the introduction of impurities. By this annealing treatment, activation of impurities, recrystallization and removing of crystal defects are carried out.

The microwave annealing is performed by heating the semiconductor wafer by irradiating microwaves to the semiconductor wafer. The lamp annealing is performed by heating the semiconductor wafer by using, e.g., a halogen lamp or xenon lamp as a heating lamp.

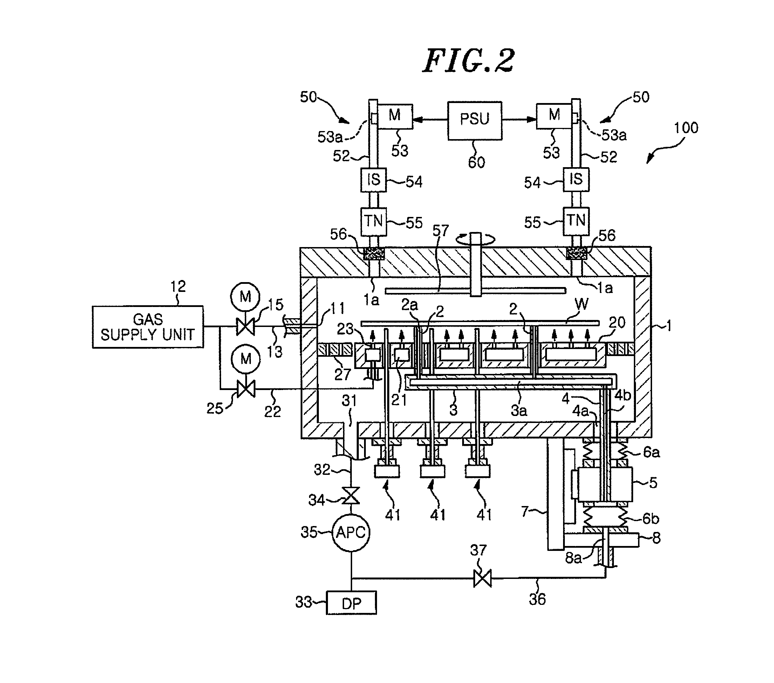

An example of a microwave annealing apparatus used in microwave annealing will be described with reference to Fig. 2.

A microwave annealing apparatus 100 has a processing chamber (applicator) 1 accommodating therein the semiconductor wafer (semiconductor substrate) W as a substrate to be processed. In the processing chamber 1, a plurality of, e.g., three (only two shown), mounting pins 2 for mounting the semiconductor wafer W are provided to protrude upward from an elevation plate 3 provided at a bottom portion of the processing chamber 1. An elevation bar 4 is provided at a bottom peripheral portion of the elevation plate 3 to extend downward while penetrating through the bottom portion of the processing chamber 1. The elevation bar 4 passes through an elevation mechanism 5. The elevation mechanism 5 is moved up and down along a guide member 7. Accordingly, the elevation bar 4, the elevation plate 3 and the mounting pins 2 are moved up and down. The semiconductor wafer W mounted on the mounting pins 2 is also moved up and down.

A support plate 8 is attached to a lower end portion of the guide member 7 at a position corresponding to the elevation mechanism 5. An insertion hole 4a through which the elevation bar 4 is inserted is formed in the bottom portion of the processing chamber 1. A bellows 6a is provided between the top surface of the elevation mechanism 5 and a peripheral portion of the insertion hole 4a of the bottom portion of the processing chamber 1. On the other hand, a bellows 6b is provided between the support plate 8 and a portion of the bottom surface of the elevation mechanism 5 which surrounds the elevation bar 4.

A gas inlet port 11 is formed in an upper sidewall of the processing chamber 1. A gas which forms an atmosphere during processing is introduced into the processing chamber 1 through a line 13 and the gas inlet port 11 from a gas supply unit 12. A flow rate control valve 15 is provided in the line 13. As the gas forming the atmosphere, an inert gas such as Ar gas, N₂ gas or the like may be used.

In the processing chamber 1, a cooling member 20 having a disk shape corresponding to the semiconductor wafer W is disposed below a support position of the semiconductor wafer W. A gas passage 21 is formed inside the cooling member 20, and a cooling gas is supplied to the gas passage 21 through a cooling gas line 22. Gas discharge holes 23 extending from the gas passage 21 are opened in the top surface of the cooling member 20. The cooling gas flowing through the gas passage 21 is discharged to the backside of the semiconductor wafer W through the gas discharge holes 23, thereby cooling the semiconductor wafer W. The cooling gas line 22 is branched from the line 13 extending from the gas supply unit 12 and inserted into the processing chamber 1. The gas for forming the atmosphere during processing is supplied as the cooling gas. A flow rate control valve 25 is provided in the cooling gas line 22. A baffle plate 27 is provided between the cooling member 20 and the inner surface of the processing chamber 1.

An exhaust port 31 is provided at the bottom portion of the processing chamber 1, and an exhaust pipe 32 is connected to the exhaust port 31. The exhaust pipe 32 is provided with a dry pump (DP) 33 for evacuating the processing chamber 1. In the exhaust pipe 32, an opening/closing valve 34 and an automatic pressure control valve (APC) 35 for controlling the pressure in the processing chamber 1 are provided between the processing chamber 1 and the dry pump 33. Thus, the inside of the processing chamber 1 is maintained at a predetermined pressure suitable for the microwave annealing. The pressure in the processing chamber 1 is maintained at a pressure at which a plasma is not generated when microwaves are irradiated into the processing chamber 1, e.g., a predetermined pressure near an atmospheric pressure.

Further, in the sidewall of the processing chamber 1, although not illustrated, a loading/unloading port for loading and unloading the semiconductor wafer is provided to be opened and closed by a gate valve.

In the mounting pins 2, suction holes 2a for vacuum attraction are formed to prevent displacement of the semiconductor wafer W. Further, a space 3a is formed in the elevation plate 3, and a hole 4b is formed in the elevation bar 4. A hole 8a is formed in the support plate 8, and a line 36 is connected to the hole 8a. The line 36 is connected to the exhaust pipe 32. Thus, by operating the dry pump 33, the semiconductor wafer W is sucked through the line 36, the hole 8a, the inside of the bellows 6b, the hole 4b, the space 3a and the suction holes 2a. As a result, the semiconductor wafer W is attracted onto the mounting pins 2. A valve 37 is provided in the line 36.

Radiation thermometers (pyrometer) 41 for measuring the temperature of the semiconductor wafer W are provided on the backside of the semiconductor wafer W. Three radiation thermometers 41 are illustrated in the drawing, but the number thereof is appropriately set.

Four (only two shown) microwave inlet ports 1a are provided in the ceiling wall of the processing chamber 1. Microwaves are supplied to the four microwave inlet ports 1a from microwave supply units 50, respectively. Each of the microwave supply units 50 has a waveguide 52 connected to each of the microwave inlet ports 1a, and a magnetron 53 (M) provided at the end of the waveguide 52 opposite to the microwave inlet port 1a to generate microwaves having a frequency of, e.g., 5.8 GHz. The introduction of the microwaves into the waveguide 52 from the magnetron 53 is carried out via a launcher 53a. In the waveguide 52, an isolator (IS) 54 for isolating reflected microwaves, and a tuner (TN) 55 for impedance matching are provided. A power is supplied to the magnetron 53 from a power supply unit (PSU) 60. A dielectric member 56 is provided between the waveguide 52 and the microwave inlet port 1a. A rotational stirring plate (stirrer) 57 which stirs the atmosphere to prevent the formation of standing waves is provided at a position above the semiconductor wafer W in the processing chamber 1. Instead of providing the rotational stirring plate 57, a mechanism for rotating the semiconductor wafer W may be provided to prevent the formation of standing waves.

By the microwave annealing apparatus 100, the microwaves are irradiated onto the semiconductor wafer W from the microwave supply units 50, and, thus, the semiconductor wafer W can be efficiently heated.

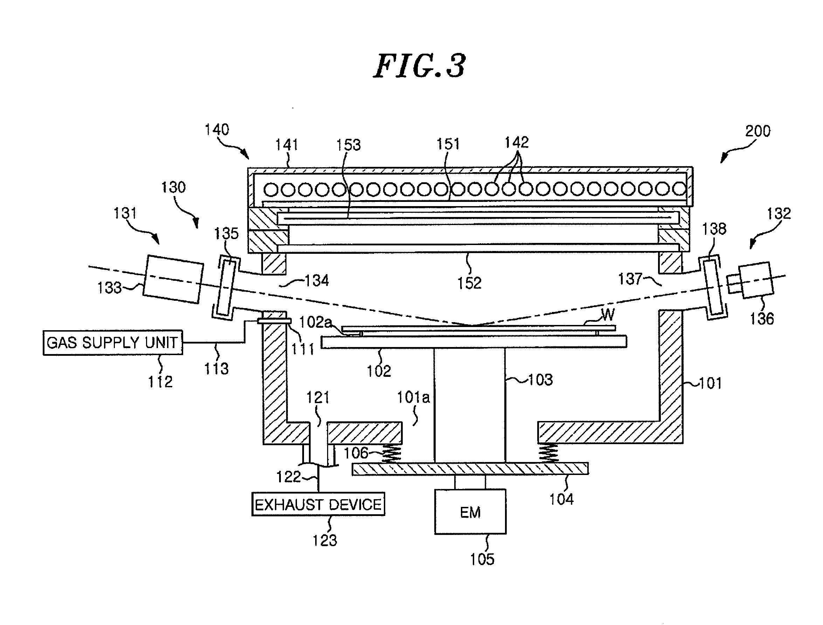

Next, an example of a lamp annealing apparatus used in the lamp annealing will be described with reference to Fig. 3.

A lamp annealing apparatus 200 has a processing chamber 101 accommodating therein a semiconductor wafer (semiconductor substrate) W as a substrate to be processed. In the processing chamber 101, a mounting table 102 for mounting the semiconductor wafer W is provided, and the semiconductor wafer W is mounted on mounting pins 102a provided on the surface of the mounting table 102. The mounting table 102 is supported by a support member 103. The support member 103 is supported by an elevation plate 104 provided therebelow through an opening 101a formed in a bottom portion of the processing chamber 101. The elevation plate 104 is movable up and down by an elevation mechanism (EM) 105. A bellows 106 is provided between the processing chamber 101 and the elevation plate 104.

A gas introducing port 111 is formed in the sidewall of the processing chamber 101. A gas which forms an atmosphere during processing is introduced into the processing chamber 101 through a line 113 and the gas introducing port 111 from a gas supply unit 112. As the gas forming the atmosphere, an inert gas such as Ar gas, N₂ gas or the like may be used. An exhaust port 121 is provided at the bottom portion of the processing chamber 101, and an exhaust pipe 122 is connected to the exhaust port 121. An exhaust device 123 including valves and a dry pump for evacuating the processing chamber 101 is provided in the exhaust pipe 122. The processing chamber 101 is evacuated by the exhaust device 123 while supplying a predetermined gas into the processing chamber 101. Accordingly, the inside of the processing chamber 101 is maintained at an atmosphere suitable for lamp heating.

A temperature measuring mechanism 130 is provided in the sidewall of the processing chamber 101. The temperature measuring mechanism 130 includes a reference light irradiating unit 131 and a radiation temperature measuring unit 132. The reference light irradiating unit 131 includes a reference light source 133 to irradiate a reference light for measuring a radiation temperature, an introduction port 134 provided in the sidewall of the processing chamber 101 to introduce the reference light from the reference light source 133 into the processing chamber 101, and a quartz glass window 135 provided in the introduction port 134.

The radiation temperature measuring unit 132 includes a dual polarization radiation thermometer 136 for measuring the radiation temperature of the semiconductor wafer W, an emission port 137 provided at a position opposite to the introduction port 134 of the sidewall of the processing chamber 101, and a quartz glass window 138 provided in the emission port 137. The dual polarization radiation thermometer 136 receives the reference light which is introduced through the introduction port 134 from the reference light source 133 and is reflected on the semiconductor wafer W, and a heat radiation light emitted from the semiconductor wafer W to measure the temperature of the semiconductor wafer W based on them.

Further, in the sidewall of the processing chamber 101, although not illustrated, a loading/unloading port for loading and unloading the semiconductor wafer is provided to be opened and closed by a gate valve.

A lamp unit 140 is provided at a top portion of the processing chamber 101 to be opposite to the semiconductor wafer W on the mounting table 102. The lamp unit 140 has a lamp housing 141 and heating lamps 142 disposed in the lamp housing 141. As the heating lamps 142, halogen lamps or xenon lamps may be used.

The lamp unit 140 and the processing chamber 101 are partitioned from each other by two transparent plates 151 and 152 and a water filter film 153 provided between the transparent plates 151 and 152. The water filter film 153 absorbs and removes a part of infrared lights from light components emitted from the heating lamps 142 such that the light wavelength of the heating lamps 142 does not interfere with the light wavelength used in the temperature measuring mechanism 130.

By the lamp annealing apparatus 200, the semiconductor wafer W can be heated to a desired temperature in a very short time of 0.01 sec or less by the heating lamps 142.

Conventionally, only lamp heating at 1000°C or higher has been performed in the annealing treatment. However, in this case, the diffusion layer spreads out and, thus, it is difficult to meet the requirements of miniaturization of semiconductor devices. Therefore, there is a demand for annealing treatment at a lower temperature.

In the case of performing the annealing treatment at a low temperature of 600°C or less, sufficient activation of impurities can be achieved singly by either of lamp annealing and microwave annealing. However, it has been found that removing of crystal defects is insufficient in the single low temperature annealing.

In contrast, it has been confirmed that by performing both microwave annealing and lamp annealing in the annealing treatment, a crystal defect removing effect can be sufficiently obtained even in the treatment at a low temperature. In particular, it is possible to further increase the crystal defect removing effect by performing the microwave annealing after the lamp annealing. It is considered that, although not clear, this is because microwaves easily act on portions having crystal defects by performing the microwave annealing after performing recrystallization by the lamp annealing.

The temperature in each of the lamp annealing and the microwave annealing is preferably in a range of 300°C to 600°C. If the temperature is lower than 300°C, activation of impurities and removing of crystal defects are not sufficient. On the other hand, if the temperature exceeds 600°C, the controllability of the diffusion region of impurities is deteriorated. The treatment time thereof is preferably in a range of 1 to 100 min. Further, as a frequency of the microwave in the microwave annealing, it is possible to apply a frequency in a range of 1 to 100 GHz, and 2.54 GHz and 5.8 GHz are preferable in the frequency range. In addition, the microwave output depends on the volume of an object to be heated, and in order to heat the semiconductor wafer to a temperature ranging from 300°C to 600°C as described above, it requires microwaves of 5.8 GHz having power density in a range of 10 to 36 W/cm³, and a power in a range of 600 to 2000 W is required for a 300 mm wafer.

Next, there will be described test results in which an effect of the annealing treatment including lamp annealing and microwave annealing has been confirmed.

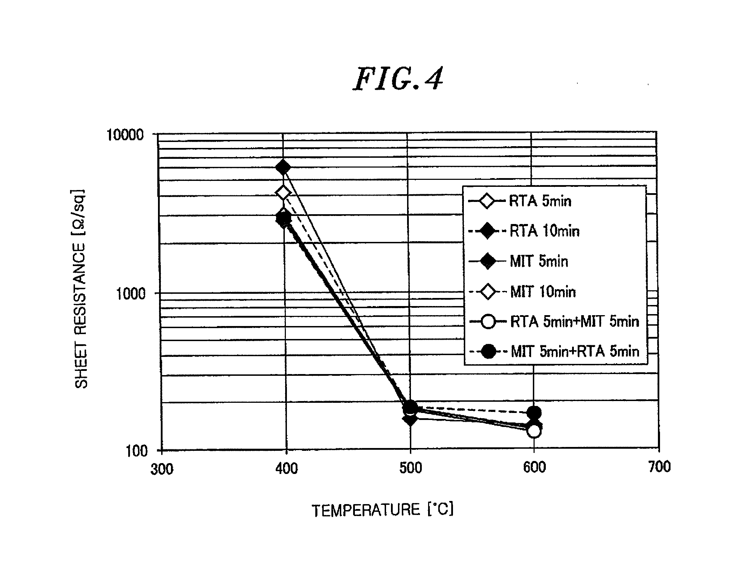

First, the activation of impurities was evaluated by measuring a resistance value of the diffusion layer by four-point probe sheet resistance measurement. In this case, impurities were doped into source and drain regions of a MOS type transistor, on a monocrystalline n-type Si wafer. That is, B ion implantation was performed under the conditions of implantation energy of 3 keV and implantation dose of 3 × 10¹⁵ ions/cm² after Ge ion implantation performed under the conditions of implantation energy of 30 keV and implantation dose of 5 × 10¹⁴ ions/cm² for pre-amorphization. With respect to the samples subjected to impurity doping as the above, under a nitrogen atmosphere, at temperatures of 400°C, 500°C and 600°C, only halogen lamp annealing (RTA) was performed for 5 min and 10 min, only microwave annealing (MIT) at a wavelength of 5.8 GHz was performed for 5 min and 10 min, microwave annealing was performed for 5 min after halogen lamp annealing was performed for 5 min, and halogen lamp annealing was performed for 5 min after microwave annealing was performed for 5 min. Then, in order to evaluate the activation of impurities, the resistance value of the diffusion layer was measured with respect to each sample by four point probe sheet resistance measurement. The results thereof are shown in Fig. 4. As shown in Fig. 4, it has been confirmed that almost the same resistance value, i.e., the same impurity activation are obtained in the annealing treatments at the same temperature.

Next, samples were prepared by performing B ion implantation after the pre-amorphization by Ge ion implantation under the above conditions, and performing the annealing treatment in a nitrogen atmosphere. As the annealing treatment, spike annealing was performed at a temperature of 1000°C by using halogen lamps (sample A), halogen lamp annealing was performed at a temperature of 600°C for 10 min (sample B), microwave annealing (5.8 GHz) was performed at a temperature of 600°C for 10 min (sample C), microwave annealing was performed at a temperature of 600°C for 5 min after halogen lamp annealing was performed at a temperature of 600°C for 5 min (sample D), and halogen lamp annealing was performed at a temperature of 600°C for 5 min after microwave annealing was performed at a temperature of 600°C for 5 min (sample E). Then, with respect to the samples A to E, the measurement of the resistance value of the diffusion layer (four point probe sheet resistance measurement) was performed to evaluate the activation of impurities, and the measurement of the cathodeluminescence (CL measurement) was performed in order to evaluate the crystal defects.

The results of the resistance measurement are shown in Table 1. As shown in Table 1, it has been confirmed that all samples exhibit the same sheet resistance, and the impurity activation effect does not change in the conventional case of performing the spike annealing at a high temperature, the case of singly performing the lamp annealing at a temperature of 600°C, the case of singly performing the microwave annealing at a temperature of 600°C, and the cases of performing both lamp annealing and microwave annealing.

**[Table 1]**

| | Sheet resistance [Ω/sq] |
|---|---|
| sample A | 155 |
| sample B | 135 |
| sample C | 140 |
| sample D | 170 |
| sample E | 128 |

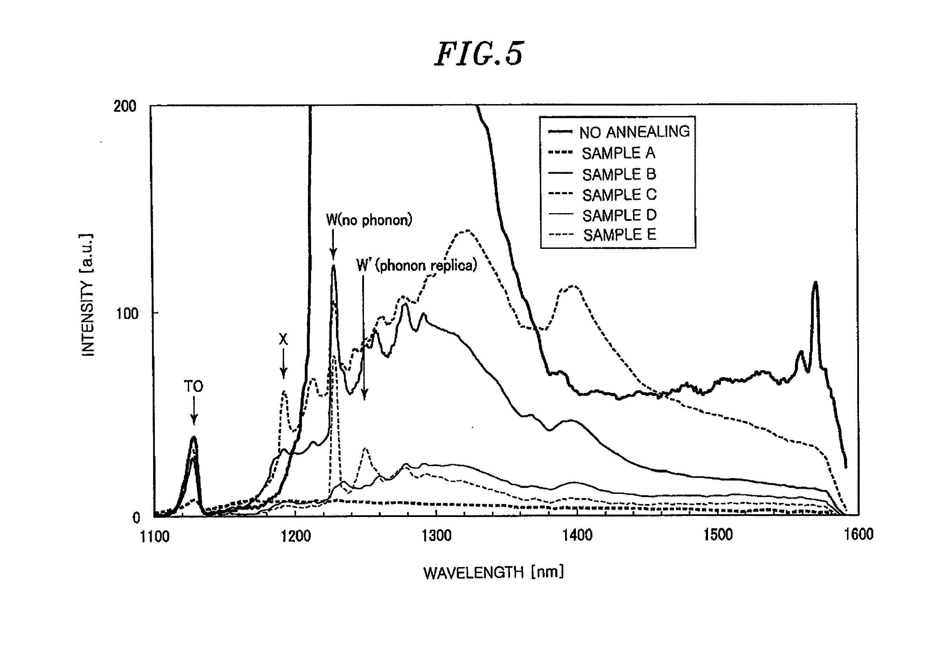

The results of the CL measurement are shown in Fig. 5. Fig. 5 is a diagram showing CL spectra, and shows the measurement results with respect to a sample before annealing in addition to the samples A to E. The CL is a light emitting phenomenon of electron beam excitation, which makes it possible to evaluate crystal defects in a simple manner. Fig. 5 shows main emission lines (peaks) observed with the CL, and it is considered that TO is an emission line due to bound excitons to which TO phonons are related, X is an emission line which is attributed to the emission caused by the composite center of Si between lattices, W (around 1213 nm) is an emission line which is attributed to the emission caused by clusters of Si between lattices, and W' (around 1228 nm) is an emission line in which the peak of W is shifted with involvement of rare gas. Therefore, the emission caused by clusters of Si between lattices is considered to be W + W'.

In the case of defect-free Si crystals, in the wavelength band shown in Fig. 5, it exhibits a spectrum having no peaks corresponding to crystal defects except TO. Thus, it can be found from Fig. 5 that nearly defect-free crystals are formed in sample A on which the spike annealing was performed at 1000°C by using halogen lamps. On the other hand, in sample B on which the lamp annealing was performed at 600°C and sample C on which the microwave annealing was performed at 600°C, the spectral intensity is entirely high, and the peaks indicating the crystal defects appear clearly. In contrast, in both samples D and E on which the lamp annealing and the microwave annealing at 600°C were performed in combination, the spectral intensity is higher than sample A, but the spectral intensity is significantly lower as compared to samples B and C. Thus, it has been confirmed that the crystal defect removing effect is enhanced by performing both the lamp annealing and the microwave annealing. Further, comparing samples D and E, the spectral intensity is lessened in sample D on which the microwave annealing was performed after the lamp annealing was performed. Thus, it has been confirmed that the effect of removing the crystal defects is further enhanced by performing microwave annealing after performing lamp annealing.

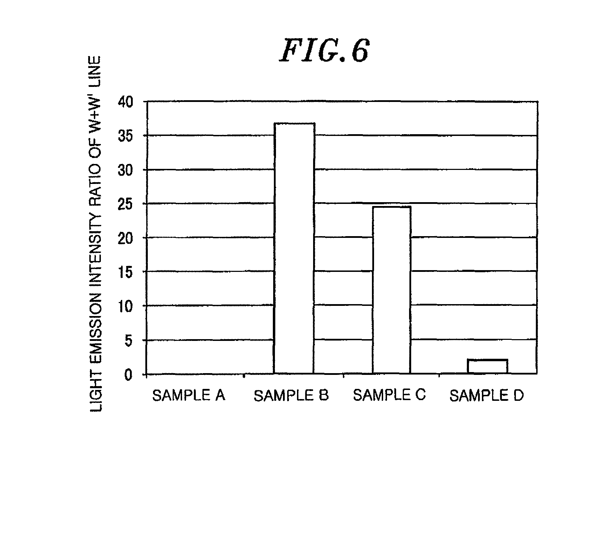

Next, with respect to samples A to D, the intensity of W + W' indicating typical crystal defects was obtained from the CL spectra. The results thereof are shown in Fig. 6. As shown in Fig. 6, in sample D on which the microwave annealing was performed after performing the lamp annealing at 600°C, the peak height of W + W' is relatively low and, thus, the crystal defects are reduced compared to sample B on which the lamp annealing was performed at 600°C and sample C on which the microwave annealing was performed at 600°C. Thus, it has been confirmed that in the case of performing each of the lamp annealing and the microwave annealing for 5 min at 600°C, the removing effect is very high compared to the case of singly performing the lamp annealing and the case of singly performing the microwave annealing with the same thermal budget.

Next, observation results of the crystal defects by using a transmission electron microscope (TEM) will be described. The TEM observation was conducted on the sample just after performing B ion implantation after the pre-amorphization by performing Ge ion implantation, and the sample on which the lamp annealing was performed for 10 min at 600°C, the sample on which the microwave annealing was performed for 10 min at 600°C, and the sample on which the microwave annealing was performed for 5 min at 600°C after performing the lamp annealing for 5 min at 600°C, after the B ion implantation.

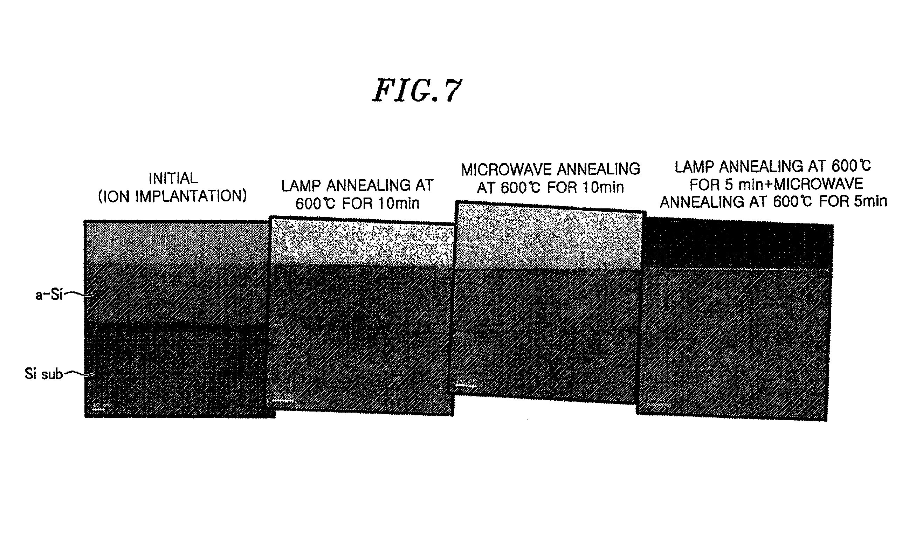

Fig. 7 shows TEM images of the cross-sections of these samples. As shown in Fig. 7, the patterns corresponding to crystal defects are observed in the case where simply performing lamp annealing at a low temperature and in the case where simply performing the microwave annealing at a low temperature, whereas the pattern corresponding to crystal defects hardly appears in the case where performing the microwave annealing at a low temperature after performing the lamp annealing at a low temperature. Thus, it has been confirmed that a high crystal defect removing effect is obtained by performing the microwave annealing at a low temperature after performing the lamp annealing at a low temperature.

As described above, in accordance with the embodiment of the present invention, the annealing treatment which includes the lamp annealing by using heating lamps and the microwave annealing by microwave irradiation is performed for activating the impurities after doping the impurities into the impurity diffusion layer forming region in the semiconductor substrate. Thus, it is possible to obtain a high crystal defect removing effect in addition to an impurity activation effect even in the annealing treatment at a low temperature.

The present invention is not limited to the above embodiment, and various modifications are possible within the scope of the invention. For example, the apparatus for performing lamp annealing and microwave annealing is not limited to the microwave annealing apparatus and the lamp annealing apparatus described in the above embodiment.

In addition, the example in which after pre-amorphizing and doping the impurity diffusion layer forming region with impurities, the activation of impurities and the recrystallization are performed by annealing has been described in the above-described embodiment. However, the amorphization is not necessary.

Furthermore, the description has been made using a silicon wafer (substrate) as an example of a semiconductor wafer (substrate), but a compound semiconductor wafer (substrate) such as SiC may be used without being limited thereto.

**Description of Reference Numerals**

| | | | |
|---|---|---|---|
| 1: | processing chamber | 1a: | microwave inlet port |
| 2: | mounting pin | 50: | microwave supply unit |
| 52: | waveguide | 53: | magnetron |
| 60: | power supply unit | 100: | microwave annealing apparatus |
| 101: | processing chamber | 102: | mounting table |
| 140: | lamp unit | 142: | heating lamp |
| 200: | lamp annealing apparatus | | |
| W: | semiconductor wafer | | |

## Claims

1. A method for manufacturing a semiconductor device, the method comprising:
doping impurities into an impurity diffusion layer forming region in a semiconductor substrate; and
activating the impurities by performing, on the semiconductor substrate, an annealing treatment including:
lamp annealing performed by using heating lamps; and
microwave annealing performed by microwave irradiation.

2. The method of claim 1, wherein the annealing treatment is performed at a temperature in a range of 300°C to 600°C.

3. The method of claim 1, wherein, in the annealing treatment, the microwave annealing is performed after the lamp annealing.

4. The method of claim 1, further comprising, before the doping, amorphizing the impurity diffusion layer forming region,
wherein the amorphized impurity diffusion layer forming region is recrystallized during the annealing treatment.

5. An annealing method for activating impurities after doping the impurities into an impurity diffusion layer forming region in a semiconductor substrate, the annealing method comprising:
lamp annealing performed by using heating lamps; and
microwave annealing performed by microwave irradiation.

6. The annealing method of claim 5, wherein the annealing method is executed at a temperature in a range of 300°C to 600°C.

7. The annealing method of claim 5, wherein the microwave annealing is performed after the lamp annealing.
